# EUROPEAN PATENT APPLICATION

(11) **EP 4 712 744 A1**
(43) Date of publication of application: **18.03.2026**
(21) Application number: 24803773.1
(22) Date of filing: 10.05.2024
(51) Int. Cl.: H10K 30/85, H10K 30/15, H10K 85/50, H10K 30/40, H10K 30/50, H10K 30/82, H10K 85/20, H10K 30/30, H10K 102/00

(54) **PEROVSKITE SOLAR CELL AND METHOD FOR PRODUCING SAME**

(30) Priority: 10.05.2023 KR 20230060283
(71) Applicant: Hanwha Solutions Corporation, Jung-gu Seoul 04541 (KR)
(72) Inventor: YI, Min Ji, Seongnam-si, Gyeonggi-do 13488 (KR); JEONG, Jun Kyeong, Seongnam-si, Gyeonggi-do 13488 (KR); KIM, Geun Jin, Seongnam-si, Gyeonggi-do 13488 (KR); LEE, Sun Hwa, Seongnam-si, Gyeonggi-do 13488 (KR)
(74) Representative: Mooser, Sebastian Thomas
(86) International application number: PCT/KR2024/006358
(87) International publication number: WO 2024/232720

(57) **Abstract**

The present invention relates to a perovskite solar cell in which an electron transport buffer layer having a three-layer structure is introduced between a perovskite light-absorbing layer and an electron transport layer, and a method for producing the same.

## Description

### TECHNICAL FIELD

The present invention relates to a perovskite solar cell in which an electron transport buffer layer having a three-layer structure is introduced between a perovskite light-absorbing layer and an electron transport layer, and a method for producing the same.

### BACKGROUND ART

In order to solve the global environmental problems caused by the depletion of fossil fuels and the use thereof, research on renewable and clean alternative energy sources such as solar energy, wind power and hydropower is actively being conducted.

Among these, interest in solar cells that directly convert electrical energy from sunlight is increasing significantly. Herein, a solar cell refers to a cell that generates current-voltage by utilizing the photovoltaic effect that generates electrons and holes by absorbing light energy from sunlight.

Currently, it is possible to manufacture n-p diode-type silicon (Si) single crystal-based solar cells with a light energy conversion efficiency of over 20%, and they are actually being used for solar power generation, and there are also solar cells using compound semiconductors such as gallium arsenide (GaAs) with an even higher conversion efficiency. However, these inorganic semiconductor-based solar cells require highly purified materials to achieve high efficiency, and thus, a lot of energy is consumed in refining the raw materials, and expensive process equipment is required in the process of using the raw materials to make a single crystal or thin film, which limits the cost of lowering the manufacturing cost of solar cells, and this has been an obstacle to large-scale utilization.

Accordingly, in order to manufacture solar cells at low cost, it is necessary to drastically reduce the cost of materials or manufacturing processes used as core elements of solar cells, and research is being conducted on perovskite solar cells that can be manufactured by using low-cost materials and processes as an alternative to inorganic semiconductor-based solar cells.

Recently, perovskite solar cells using (NH₃CH₃)PbX₃ (X = I, Br, Cl), which is a halogen compound with a perovskite structure, as a photoactive agent have been developed, and research is being conducted toward commercialization. The general structural formula of the perovskite structure is the ABX₃ structure, where an anion is located in the X position, a large cation is located in the A position, and a small cation is located in the B position.

Meanwhile, perovskite solar cells are being developed in the structure of P-IN perovskite single solar cells or two-terminal perovskite/silicon tandem solar cells. In the case of a two-terminal perovskite/silicon tandem solar cell, a recombination layer is formed on glass and a lower silicon solar cell, and then, upper perovskite solar cell layers, such as a hole transport layer, a perovskite light-absorbing layer, an electron transport layer and a transparent electrode, are sequentially formed to fabricate a two-terminal perovskite/silicon tandem solar cell. In this case, electrons and holes separated from the perovskite light-absorbing layer are transferred to the electron transport layer and the hole transport layer, respectively.

The holes separated from the perovskite light-absorbing layer are not only transferred to the lower hole transport layer, but also to the upper layer where the electron transport layer exists. In this case, there is a problem in that charge recombination occurs at the electron transport layer interface due to energy level mismatch, which reduces the performance of the solar cell.

In addition, when forming the electron transport layer, there is a problem in that it is difficult to form a uniform ultra-thin film because the atomic layer does not grow uniformly in the initial nuclear growth stage, which not only reduces the solar cell performance, but also reduces the reproducibility and stability of the solar cell due to the instability of the thin film formation caused by the deterioration of the interface uniformity.

### DISCLOSURE

### TECHNICAL PROBLEM

The present invention has been devised to overcome the above-described problem, and is directed to providing a perovskite solar cell, in which an electron transport buffer layer having a three-layer structure is introduced between a perovskite light-absorbing layer and an electron transport layer to prevent the movement of holes to the electron transport layer, improve selective transport of electrons, and thereby minimize decrease in performance of the perovskite solar cell and secure stability, and a method for producing the same.

### TECHNICAL SOLUTION

In order to solve the above-described problems, the perovskite solar cell of the present invention may include a laminate in which a hole transport layer, a perovskite light-absorbing layer, an electron transport layer, a transparent electrode and a metal electrode are sequentially laminated, wherein an electron transport buffer layer may be formed between the perovskite light-absorbing layer and the electron transport layer.

In a preferred embodiment of the present invention, the electron transport buffer layer may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

In a preferred embodiment of the present invention, the electron transport buffer layer may be a structure in which a passivation buffer layer, a carbon-based electron transport layer and a hole blocking buffer layer are sequentially laminated.

In a preferred embodiment of the present invention, the passivation buffer layer may be laminated on one surface of the perovskite light-absorbing layer, and the hole blocking buffer layer may be laminated on one surface of the electron transport layer.

In a preferred embodiment of the present invention, the passivation buffer layer may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

In a preferred embodiment of the present invention, the hole blocking buffer layer may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

In a preferred embodiment of the present invention, the carbon-based electron transport layer may include a fullerene series organic material.

In a preferred embodiment of the present invention, the fullerene series organic material may include one or more selected from C₆₀, C₇₀, PC60BM and PC70BM.

In a preferred embodiment of the present invention, the carbon-based electron transport layer and the passivation buffer layer may have a thickness ratio of 1:0.01 to 0.2.

In a preferred embodiment of the present invention, the carbon-based electron transport layer and the hole blocking buffer layer may have a thickness ratio of 1:0.01 to 0.2.

In a preferred embodiment of the present invention, the passivation buffer layer may have an average thickness of 0.5 to 5 nm.

In a preferred embodiment of the present invention, the hole blocking buffer layer may have an average thickness of 0.5 to 5 nm.

In a preferred embodiment of the present invention, the carbon-based electron transport layer may have an average thickness of 3 to 30 nm.

In a preferred embodiment of the present invention, the electron transport layer and electron transport buffer layer may have a thickness ratio of 1:1.1 to 2.4.

In a preferred embodiment of the present invention, the electron transport layer may have an average thickness of 3 to 30 nm.

In a preferred embodiment of the present invention, the perovskite solar cell of the present invention may be a p-i-n structured perovskite solar cell, an n-i-p inverted structured perovskite solar cell, a tandem perovskite solar cell or a tandem silicon/perovskite heterojunction solar cell.

Meanwhile, the method for producing a perovskite solar cell according to the present invention may include step 1 of forming a perovskite light-absorbing layer on top of a hole transport layer; step 2 of forming an electron transport buffer layer on top of the perovskite light-absorbing layer through a deposition process or a solution process; and step 3 of sequentially forming an electron transport layer, a transparent electrode and a metal electrode on top of the electron transport buffer layer, wherein the electron transport buffer layer may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

In a preferred embodiment of the present invention, step 2 may include step 2-1 of forming a passivation buffer layer on top of a perovskite light-absorbing layer through a deposition process or a solution process; step 2-2 of forming a carbon-based electron transport layer on top of the passivation buffer layer through a deposition process or a solution process; and step 2-3 of forming a hole blocking buffer layer on top of the carbon-based electron transport layer through a deposition process or a solution process.

Furthermore, the tandem silicon/perovskite heterojunction solar cell of the present invention may be a heterojunction solar cell in which a solar cell, a transparent conductive layer, a hole transport layer, a perovskite light-absorbing layer, an electron transport buffer layer, an electron transport layer, a transparent electrode and a metal electrode are sequentially laminated, wherein the electron transport buffer layer may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

In a preferred embodiment of the present invention, the solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.

### ADVANTAGEOUS EFFECTS

The perovskite solar cell of the present invention forms a physical barrier by introducing an electron transport buffer layer having a three-layer structure between the perovskite light-absorbing layer and the electron transport layer, thereby imparting physical passivation characteristics, improving hole blocking characteristics to reduce shunt occurrence within the solar cell, and increasing shunt resistance to improve the fill factor (FF), so as to improve the performance of a solar cell.

### DESCRIPTION OF DRAWINGS

FIG. 1 is a cross-sectional diagram illustrating an electron transport buffer layer according to a preferred embodiment of the present invention.
FIG. 2 is a graph showing the current density according to an applied voltage for each of the tandem silicon/perovskite heterojunction solar cells produced in Examples 1 to 3.

### MODES OF THE INVENTION

Hereinafter, the present invention will be described in more detail.

In conventional perovskite solar cells, holes separated from a perovskite light-absorbing layer do not only move to a lower hole transport layer, but also move to an upper layer where the electron transport layer exists. In this case, there is a problem in that charge recombination occurs at the electron transport layer interface due to energy level mismatch, which reduces the performance of a solar cell.

In addition, when forming an electron transport layer, there is a problem in that it is difficult to form a uniform ultra-thin film because the atomic layer does not grow uniformly in the initial nuclear growth stage, which not only reduces the solar cell performance, but also reduces the reproducibility and stability of the solar cell due to the instability of the thin film formation caused by the deterioration of the interface uniformity.

Accordingly, the present invention relates to a perovskite solar cell in which an electron transport buffer layer having a three-layer structure is introduced between a perovskite light-absorbing layer and an electron transport layer to prevent the movement of holes to the electron transport layer, improve selective transport of electrons, and thereby minimize decrease in performance of the perovskite solar cell and secure stability.

The perovskite solar cell of the present invention may be a p-i-n structured perovskite solar cell, an n-i-p inverted structured perovskite solar cell, a tandem perovskite solar cell or a tandem silicon/perovskite heterojunction solar cell, preferably, it may be a tandem silicon/perovskite heterojunction solar cell, and may be a solar cell including a laminate in which a hole transport layer (HTL), a perovskite light-absorbing layer, an electron transport layer (ETL), a transparent electrode and a metal electrode are sequentially laminated.

In addition, the perovskite solar cell of the present invention may have an electron transport buffer layer formed between the perovskite light-absorbing layer and the electron transport layer.

For example, in a preferred embodiment, when the perovskite solar cell of the present invention is a tandem silicon/perovskite heterojunction solar cell, it may be a heterojunction solar cell in which a solar cell, a transparent conductive layer, a hole transport layer, a perovskite light-absorbing layer, an electron transport buffer layer, an electron transport layer, a transparent electrode and a metal electrode are sequentially laminated.

The solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fluorine-sensitized solar cell or a Group 3-5 compound solar cell.

In addition, there is no separate limitation on the thickness of the solar cell, but it may preferably have a thickness of 140 to 250 µm, and more preferably 160 to 200 µm.

The transparent conductive layer is a layer that induces the recombination of electrons and holes generated in the solar cell and the perovskite light-absorbing layer described below, and it may be a transparent thin film on which indium tin oxide (ITO), fluorine-doped tin oxide (FTO), Sb₂O₃-doped tin oxide (ATO), gallium-doped tin oxide (GTO), tin-doped zinc oxide (ZTO), gallium-doped ZTO (ZTO:Ga), indium gallium zinc oxide (IGZO), indium-doped zinc oxide (IZO) or aluminum-doped zinc oxide (AZO) is deposited.

In addition, as an example of forming a transparent conductive layer, when using a silicon solar cell doped with n or p-type impurities as a solar cell, the silicon solar cell doped with n or p-type impurities is treated with hydrofluoric acid to remove a SiOₓ oxide film, and then, the remaining hydrofluoric acid is removed by using ultrapure water. Then, a transparent conductive layer may be formed on top of a silicon solar cell from which the oxide film has been removed through a sputtering process.

In addition, the thickness of the transparent conductive layer is not particularly limited, but may preferably have a thickness of 5 nm to 50 nm, and more preferably 15 nm to 25 nm.

The hole transport layer (HTL) is a layer that transports holes formed in the perovskite light-absorbing layer described below while blocking the movement of electrons, and may include an inorganic and/or organic hole transport material.

In this case, the inorganic hole transport material may include one or more selected from nickel oxide (NiOₓ), CuSCN, CuCrO₂, CuI, MoO and V₂O₅.

In addition, the organic hole transport material may include one or more selected from a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine compound, a porphyrin-based compound, a phthalocyanine-based compound, a polythiophene derivative, a polypyrrole derivative, a polyparaphenylenevinylene derivative, pentacene, coumarin 6 (3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc(boron subphthalocyanine chloride) and N3 (cis-di(thiocyanato)-bis(2,2'-bipyridyl-4,4'-dicarboxylic acid)-ruthenium(II), P3HT(poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2"-ethylhexyloxy)-p-phenylene vinylene]), P3OT (poly(3-octyl thiophene)), POT (poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-di-pmethoxyphenyl amine)-9,9,9'-spirobi fluorine]), PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4',7,-di-2-thienyl-2',1', 3'-benzothiadiazole)]), PFO-DBT (poly[2,7-.9,9-(dioctyl-fluorene)-alt-5,5-(4',7'-di-2-.thienyl-2',1',3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly [[9-(1-octylnonyl)-9H-carbazole-2,7-diyl]-2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS (poly(3,4-ethylenedioxythiophene) poly(styrenesulfonate), PTAA (poly(triarylamine)), 2-PACz, MeO-2PACz, Br-2PACz, Me-4PACz, MeO-4PACz and 6-PACz.

In addition, methods for forming the hole transport layer include a coating method and a vacuum deposition method, and methods for applying the hole transport layer include a gravure coating method, a bar coating method, a printing method, a spray method, a spin coating method, a dip method and a die coat method.

In addition, the thickness of the hole transport layer is not particularly limited, but may preferably have a thickness of 5 nm to 40 nm, and more preferably 10 nm to 30 nm.

The perovskite light-absorbing layer may include a general perovskite material applied to a light-absorbing layer of a solar cell, and as a preferred example, it may include a perovskite material represented by Chemical Formula 1 below.

[Chemical Formula 1] CMX₃

In Chemical Formula 1 above, C is a monovalent cation, and may include an amine, ammonium, a Group 1 metal, a Group 2 metal and/or other cations or cation-like compounds, and preferably, it may be formamidinium (FA), methylammonium (MA), FAMA, CsFAMA, CsFA or N(R)₄₊ (herein, R may be the same or different groups, and R is a straight-chain alkyl group having 1 to 5 carbon atoms, a branched alkyl group having 3 to 5 carbon atoms, a phenyl group, an alkylphenyl group, an alkoxyphenyl group or an alkyl halide).

In addition, M in Chemical Formula 1 is a divalent cation, and may include one or two selected from Fe, Co, Ni, Cu, Sn, Pb, Bi, Ge, Ti, Eu and Zr.

In addition, X in Chemical Formula 1 is a monovalent anion, and may include one or more halide elements selected from F, Cl, Br and I and/or a Group 16 anion. As a preferred example, X may be IₓBr₃₋ₓ (0 ≤ x ≤ 3).

In addition, a preferable embodiment of Chemical Formula 1 may be FAPbIₓBr₃₋ₓ (0 ≤ x ≤ 3), MAPbIₓBr₃₋ₓ (0 ≤ x ≤ 3), CSFAPbIₓBr₃₋ₓ (0 ≤ x ≤ 3), CSMAFAPbIₓBr₃₋ₓ (0 ≤ x ≤ 3), CH₃NH₃PbX₃ (X= Cl, Br, I, BrI₂ or Br₂I), CH₃NH₃SnX₃ (X= Cl, Br or I), CH(=NH)NH₃PbX₃ (X= Cl, Br, I, BrI₂ or Br₂I) or CH(=NH)NH₃SnX₃ (X= Cl, Br or I).

Meanwhile, in the perovskite solar cell of the present invention, the perovskite light-absorbing layer may be a single layer composed of the same perovskite material, or may be a multilayer structure in which multiple layers composed of different perovskite materials are laminated, and may include a heterogeneous perovskite material that is different from one type of perovskite material having a pillar shape such as a columnar shape, a plate shape, a needle shape, a wire shape or a rod shape inside the light-absorbing layer composed of the one type of perovskite material.

In addition, methods for forming the perovskite light-absorbing layer include a coating method and a vacuum deposition method, and methods for applying the layer include a gravure coating method, a bar coating method, a printing method, a spray method, a spin coating method, a dip method, an inkjet coating method and a die coat method.

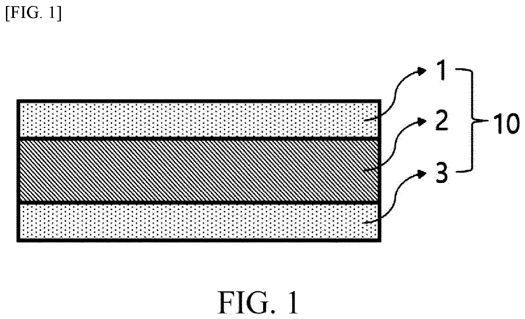

Referring to FIG. 1, an electron transport buffer layer 10 may be formed on top of the perovskite light-absorbing layer through a deposition process or a solution process.

In this case, deposition may be performed by a general deposition process used in the art, and preferably, a vacuum deposition process may be performed. In addition, the solution process may be performed through a spin coating process.

In addition, the electron transport buffer layer 10 may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂), and preferably, it may include lithium fluoride (LiF).

Specifically, the electron transport buffer layer 10 may have a structure in which a passivation buffer layer 3, a carbon-based electron transport layer 2 and a hole blocking buffer layer 1 are sequentially laminated. In this case, the passivation buffer layer 3 may be laminated on one surface of the perovskite light-absorbing layer, and the hole blocking buffer layer 1 may be laminated on one surface of the electron transport layer.

The passivation buffer layer 3 is a layer that is included in the perovskite solar cell of the present invention and acts as a passivation layer, and may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃), and calcium fluoride (CaF₂), and preferably, it may include lithium fluoride (LiF).

In addition, the passivation buffer layer 3 may have an average thickness of 0.5 to 5 nm, preferably an average thickness of 0.5 to 1.5 nm. If the average thickness is less than 0.5 nm, there may be a problem of energy mismatch due to the loss of passivation characteristics, and if it is more than 5 nm, there may be a problem of the loss of charge transfer capability due to insulation characteristics.

The carbon-based electron transport layer 2 may include a fullerene series organic material. In this case, the fullerene series organic material may include one or more selected from C₆₀, C₇₀, PC60BM and PC70BM, and preferably it may include C₆₀.

In addition, the carbon-based electron transport layer 2 may have an average thickness of 3 to 30 nm, preferably an average thickness of 5 to 20 nm, and more preferably an average thickness of 11 to 15 nm. If the average thickness is less than 3 nm, there may be a problem of reduced charge transfer capability due to failure to form uniformly on the rough surface of the perovskite light-absorbing layer, and if it is more than 30 nm, there may be a problem of reduced characteristics of the solar cell due to the absorption of light that should be absorbed by the perovskite light-absorbing layer, thereby hindering the light-receiving characteristics of the perovskite light-absorbing layer.

The hole blocking buffer layer 1 is a layer that is included in the perovskite solar cell of the present invention and plays a hole blocking role, and may include one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂), and preferably, it may include lithium fluoride (LiF).

In addition, the hole blocking buffer layer 1 may have an average thickness of 0.5 to 5 nm, and preferably an average thickness of 0.5 to 1.5 nm. If the average thickness is less than 0.5 nm, there is a problem in that it may hinder the improvement of energy matching and may hinder the uniform growth of atomic layers in the initial nucleus growth stage during the formation of the electron transport layer, making it difficult to form a uniform ultra-thin film. If it is more than 5 nm, there may be a problem of reduced charge transfer characteristics due to insulating characteristics.

Meanwhile, the carbon-based electron transport layer 2 and the passivation buffer layer 3 may have a thickness ratio of 1:0.01 to 0.2, and preferably 1:0.05 to 0.08.

In addition, the carbon-based electron transport layer 2 and the hole blocking buffer layer 1 may have a thickness ratio of 1:0.01 to 0.2, and preferably 1:0.05 to 0.08.

The electron transporting layer (ETL) is a layer that transports electrons formed in the perovskite light-absorbing layer while blocking the movement of holes, and may include one or more selected from tin oxide (SnOx), nickel oxide (NiOx), tin oxide (SnO₂), titanium dioxide (TiO₂), zinc oxide (ZnO), barium tin oxide (BaSnO₃), niobium hydroxide (NbOH) and niobium pentoxide (Nb₂O₅).

In addition, methods for forming the electron transport layer include a coating method, an ALD deposition method and/or a vacuum deposition method, and methods for applying the electron transport layer include a gravure coating method, a bar coating method, a printing method, a spray method, a spin coating method, a dip method and a die coat method.

In addition, the thickness of the electron transport layer is not particularly limited, but may have an average thickness of preferably 3 to 30 nm, more preferably 3 to 15 nm, and even more preferably 10 to 13 nm. In this case, the electron transport layer and the electron transport buffer layer may have a thickness ratio of 1:1.1 to 2.4, and preferably 1:1.36 to 2.04.

The transparent electrode may be formed on an upper part of the electron transport layer through a deposition process. In this case, the deposition may be performed by using a general deposition process used in the art, and preferably, the deposition process may be performed by using a sputtering method.

In addition, the transparent electrode may be a transparent thin film in which indium tin oxide (ITO), fluorine-doped tin oxide (FTO), Sb₂O₃-doped tin oxide (ATO), gallium-doped tin oxide (GTO), tin-doped zinc oxide (ZTO), gallium-doped ZTO (ZTO:Ga), indium gallium zinc oxide (IGZO), indium-doped zinc oxide (IZO) or aluminum-doped zinc oxide (AZO) is deposited.

In addition, there is no separate limitation on the thickness of the transparent electrode, but it may preferably have a thickness of 50 to 200 nm, and more preferably 60 to 140 nm.

The metal electrode may be formed by patterning a metal material on top of a transparent electrode. Specifically, the patterning process is largely composed of deposition, exposure (lithography) and etching. The metal electrode may be formed on top of the transparent electrode through the process of spreading a metal material in the form of a thin film on one surface of a substrate, printing a pattern by exposure, and then removing unnecessary portions. In addition, the patterning process may also be performed through a screen printing method using a metal paste including a metal material.

In this case, the metal material may include one or more selected from Pt, Au, Ni, Cu, Ag, In, Ru, Pd, Rh, Ir, Os, C and a conductive polymer.

Additionally, there is no separate limitation on the thickness of the metal electrode, but it may preferably have a thickness of 50 nm to 2.5 µm.

Meanwhile, the method for producing a perovskite solar cell according to the present invention may include step 1 of forming a perovskite light-absorbing layer on top of a hole transport layer, step 2 of forming an electron transport buffer layer on top of the perovskite light-absorbing layer through a deposition process or a solution process, and step 3 of sequentially forming an electron transport layer, a transparent electrode and a metal electrode on top of the electron transport buffer layer

In this case, the electron transport buffer layer may have a structure in which a passivation buffer layer 3, a carbon-based electron transport layer 2 and a hole blocking buffer layer 1 are sequentially laminated.

Specifically, step 2 of the method for producing a perovskite solar cell according to the present invention may include step 2-1 of forming a passivation buffer layer on top of a perovskite light-absorbing layer through a deposition process or a solution process, step 2-2 of forming a carbon-based electron transport layer on top of the passivation buffer layer through a deposition process or a solution process, and step 2-3 of forming a hole blocking buffer layer on top of the carbon-based electron transport layer through a deposition process or a solution process.

More specifically, the passivation buffer layer may be formed through a vacuum deposition process, the carbon-based electron transport layer may be formed through a vacuum deposition process, and the hole blocking buffer layer may be formed through a vacuum deposition process.

Hereinafter, the present invention will be described more specifically through examples, but the following examples do not limit the scope of the present invention, and should be interpreted as helping to understand the present invention.

### Example 1: Production of tandem silicon/perovskite heterojunction solar cell

(1) A silicon solar cell (thickness: 180 µm) doped with n or p-type impurities was prepared, a SiOₓ oxide film was removed by hydrofluoric acid treatment, and the remaining hydrofluoric acid was removed by using ultrapure water. A 20 nm thick transparent conductive layer (ITO) was formed on top of the silicon solar cell from which the oxide film was removed through a sputtering process.
(2) Next, a 20 nm thick hole transport layer (NiOₓ) was formed on top of the transparent conductive layer through sputtering vacuum deposition.
(3) Next, a yellow light-absorbing layer solution which was formed by being dissolved in dimethylformamide (DMF) and dimethyl sulfoxide (DMSO) was formed on top of the hole transport layer through spin coating, and a perovskite light-absorbing layer (CSFAPbIₓBr_{3-X} (0 ≤ x ≤ 3)) having a perovskite crystal structure with a thickness of 300 nm was formed by heat treatment at 125°C for 20 minutes.
(4) Next, lithium fluoride (LiF) was deposited on top of the perovskite light-absorbing layer through a vacuum deposition process to form a passivation buffer layer with an average thickness of 1 nm.
(5) Next, C₆₀ fullerene was deposited on top of the passivation buffer layer through a vacuum deposition process to form a carbon-based electron transport layer with an average thickness of 15 nm.
(6) Next, lithium fluoride (LiF) was deposited on top of the carbon-based electron transport layer through a vacuum deposition process to form a hole-blocking buffer layer with an average thickness of 1 nm.
(7) Next, an electron transport layer (SnO₂) with an average thickness of 10 nm was formed on top of the hole blocking buffer layer through an atomic layer deposition (ALD) process.
(8) Next, a 75 nm thick transparent electrode (ITO) was formed on top of the electron transport layer through a sputtering process.
(9) Finally, silver (Ag) was deposited on top of the transparent electrode at a pressure of 1×10⁻⁷ torr to a thickness of 100 nm to form a metal electrode, thereby producing a tandem silicon/perovskite heterojunction solar cell in which a silicon solar cell, a transparent conductive layer, a hole transport layer, a perovskite light-absorbing layer, a passivation buffer layer, a carbon-based electron transport layer, a hole blocking buffer layer, an electron transport layer, a transparent electrode and a metal electrode were sequentially laminated.

### Example 2: Production of tandem silicon/perovskite heterojunction solar cell

(1) A silicon solar cell (thickness: 180 µm) doped with n or p-type impurities was prepared, a SiOₓ oxide film was removed by hydrofluoric acid treatment, and the remaining hydrofluoric acid was removed by using ultrapure water. A 20 nm thick transparent conductive layer (ITO) was formed on top of the silicon solar cell from which the oxide film was removed through a sputtering process.
(2) Next, a 20 nm thick hole transport layer (NiOx) was formed on top of the transparent conductive layer through sputtering vacuum deposition.
(3) Next, a yellow light-absorbing layer solution which was formed by being dissolved in dimethylformamide (DMF) and dimethyl sulfoxide (DMSO) was formed on top of the hole transport layer through spin coating, and a perovskite light-absorbing layer (CSFAPbIₓBr_{3-X} (0 ≤ x ≤ 3)) having a perovskite crystal structure with a thickness of 300 nm was formed by heat treatment at 125°C for 20 minutes.
(4) Next, lithium fluoride (LiF) was deposited on top of the perovskite light-absorbing layer through a vacuum deposition process to form a passivation buffer layer with an average thickness of 1 nm.
(5) Next, C₆₀ fullerene was deposited on top of the passivation buffer layer through a vacuum deposition process to form a carbon-based electron transport layer with an average thickness of 15 nm.
(6) Next, an electron transport layer (SnO₂) with an average thickness of 10 nm was formed on top of the carbon-based electron transport layer through an atomic layer deposition (ALD) process.
(7) Next, a 75 nm thick transparent electrode (ITO) was formed on top of the electron transport layer through a sputtering process.
(8) Finally, silver (Ag) was deposited on top of the transparent electrode at a pressure of 1×10⁻⁷ torr to a thickness of 100 nm to form a metal electrode, thereby manufacturing a tandem silicon/perovskite heterojunction solar cell in which a silicon solar cell, a transparent conductive layer, a hole transport layer, a perovskite light-absorbing layer, a passivation buffer layer, a carbon-based electron transport layer, an electron transport layer, a transparent electrode and a metal electrode were sequentially laminated.

### Example 3: Production of tandem silicon/perovskite heterojunction solar cell

(1) A silicon solar cell (thickness: 180 µm) doped with n or p-type impurities was prepared, a SiOₓ oxide film was removed by hydrofluoric acid treatment, and the remaining hydrofluoric acid was removed by using ultrapure water. A 20 nm thick transparent conductive layer (ITO) was formed on top of the silicon solar cell from which the oxide film was removed through a sputtering process.
(2) Next, a 20 nm thick hole transport layer (NiOₓ) was formed on top of the transparent conductive layer through sputtering vacuum deposition.
(3) Next, a yellow light-absorbing layer solution which was formed by being dissolved in dimethylformamide (DMF) and dimethyl sulfoxide (DMSO) was formed on top of the hole transport layer through spin coating, and a perovskite light-absorbing layer (CSFAPbIₓBr_{3-X} (0 ≤ x ≤ 3)) having a perovskite crystal structure with a thickness of 300 nm was formed by heat treatment at 100°C for 20 minutes.
(4) Next, PCBM was coated on top of the perovskite light-absorbing layer through a solution process to form a passivation buffer layer with an average thickness of 10 nm.
(5) Next, C₆₀ fullerene was deposited on top of the passivation buffer layer through a vacuum deposition process to form a carbon-based electron transport layer with an average thickness of 15 nm.
(6) Next, an electron transport layer (SnO₂) with an average thickness of 10 nm was formed on top of the hole blocking buffer layer through an atomic layer deposition (ALD) process.
(7) Next, a 75 nm thick transparent electrode (ITO) was formed on top of the electron transport layer through a sputtering process.
(8) Finally, silver (Ag) was deposited on top of the transparent electrode at a pressure of 1×10⁻⁷ torr to a thickness of 100 nm to form a metal electrode, thereby producing a tandem silicon/perovskite heterojunction solar cell in which a silicon solar cell, a transparent conductive layer, a hole transport layer, a perovskite light-absorbing layer, a passivation buffer layer, a carbon-based electron transport layer, a hole blocking buffer layer, an electron transport layer, a transparent electrode and a metal electrode were sequentially laminated.

### Experimental Example 1: Measurement of solar cell performance

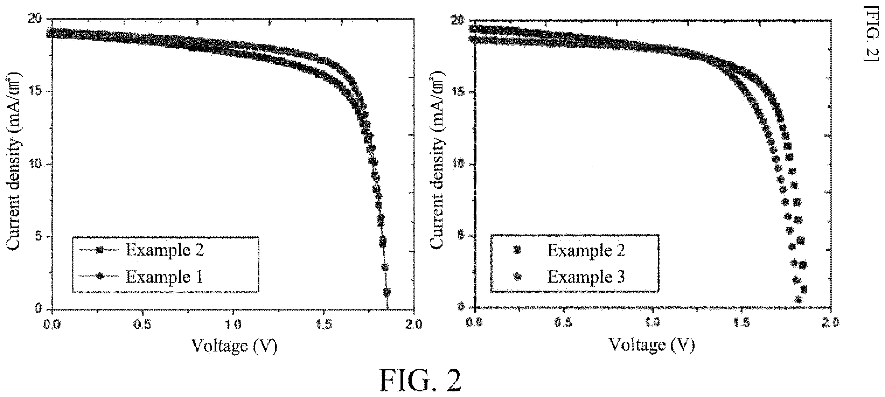

FIG. 2 is a set of graphs showing the current density according to an applied voltage for each of the tandem silicon/perovskite heterojunction solar cells produced in Examples 1 to 3, as measured by the LED Lamp-based J-V measurement method.

As can be confirmed through the left graph of FIG. 2, the tandem silicon/perovskite heterojunction solar cell produced in Example 1 having a structure in which a passivation buffer layer, a carbon-based electron transport layer, a hole blocking buffer layer and an electron transport layer were sequentially laminated physically blocked holes moving to the electron transport layer, thereby enhancing the hole blocking characteristic, and only electrons were selectively transported, thereby minimizing charge recombination at the interface, and as a result, it suppressed shunting and induced an improvement in fill factor. In addition, it was confirmed that the hole blocking buffer layer in the form of an ultra-thin film enabled the formation of a dense thin film, thereby suppressing molecules that cause charge loss and facilitating charge capture, so as to increase the short-circuit current density.

In addition, as can be confirmed through the right graph of FIG. 2, it was confirmed that the tandem silicon/perovskite heterojunction solar cell produced in Example 1 using lithium fluoride (LiF) as a passivation buffer layer had an improved open circuit voltage by improving energy matching and had an enhanced short-circuit current density by inducing only the passivation effect, compared to the tandem silicon/perovskite heterojunction solar cell produced in Example 3 using PCBM as a passivation buffer layer.

In addition, for each of the tandem silicon/perovskite heterojunction solar cells produced in Examples 1 to 3, the efficiency was measured by using a solar simulation device and a JV Keithley device, and the initial JV curve was used, and the results are shown in Table 1 below.

**[Table 1]**

| Classification | Open Circuit Voltage (V_{oc}, V) | Short Circuit Current Density (J_{sc}, mA/cm²) | Feel Factor (FF) | Power Conversion Efficiency (PCE, %) | Series Resistance (Rₛ, Ω) | Parallel Resistance (Rₛₕ, Ω) |
|---|---|---|---|---|---|---|
| Example 1 | 1.852 | 19.59 | 74.39 | 26.99 | 4.41 | 1602.62 |
| Example 2 | 1.855 | 19.42 | 69.70 | 25.11 | 5.17 | 1440.23 |
| Example 3 | 1.806 | 18.66 | 68.85 | 23.20 | 8.15 | 2906.29 |

As can be confirmed in Table 1 above, it was confirmed that the tandem silicon/perovskite heterojunction solar cell manufactured in Example 1 had the most excellent open circuit voltage, short-circuit current density, fill factor and power conversion efficiency values.

### Experimental Example 2: Analysis of Surface Chemical Properties of the Electron Transport Layer

The surface chemical properties of the electron transport layer of each of the tandem silicon/perovskite heterojunction solar cells fabricated in Examples 1 and 2 were analyzed using XPS (XPS) and are shown in Table 2 below.

**[Table 2]**

| Classification | WF | VBM | O/Sn | N/Sn |
|---|---|---|---|---|
| Example 1 | 4.19 | 3.58 | 1.93 | 0.062 |
| Example 2 | 4.31 | 3.47 | 1.90 | 0.073 |

As can be confirmed in Table 2 above, the tandem silicon/perovskite heterojunction solar cell produced in Example 1 had a decreased work function (WF) and an increased valence band maximum (VBM) compared to the tandem silicon/perovskite heterojunction solar cell produced in Example 2, confirming that it is advantageous for charge transfer. In addition, the tandem silicon/perovskite heterojunction solar cell produced in Example 1 had an increased O/Sn ratio and a decreased N/Sn ratio compared to the tandem silicon/perovskite heterojunction solar cell produced in Example 2, confirming that a film with fewer surface defects in the electron transport layer and a stoichiometrically stable film was formed.

In conclusion, it was confirmed that the tandem silicon/perovskite heterojunction solar cell produced in Example 1 was capable of increasing the open circuit voltage through energy agreement matching and increasing the short-circuit current density and fill factor through enhanced surface properties.

The above has been illustrated and described with respect to specific embodiments. However, it is not limited to the above-described embodiments, and those skilled in the art to which the invention pertains can make various modifications and implementations without departing from the gist of the technical idea of the invention described in the claims below.

## Claims

1. A perovskite solar cell, comprising:
a laminate in which a hole transport layer, a perovskite light-absorbing layer, an electron transport layer, a transparent electrode and a metal electrode are sequentially laminated,
wherein an electron transport buffer layer is formed between the perovskite light-absorbing layer and the electron transport layer, and
wherein the electron transport buffer layer comprises one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

2. The perovskite solar cell of claim 1, wherein the electron transport buffer layer is a structure in which a passivation buffer layer, a carbon-based electron transport layer and a hole blocking buffer layer are sequentially laminated, and
wherein the passivation buffer layer is laminated on one surface of the perovskite light-absorbing layer, and the hole blocking buffer layer is laminated on one surface of the electron transport layer.

3. The perovskite solar cell of claim 2, wherein each of the passivation buffer layer and the hole blocking buffer layer comprises one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂), and
wherein the carbon-based electron transport layer comprises a fullerene series organic material.

4. The perovskite solar cell of claim 3, wherein the fullerene series organic material comprises one or more selected from C₆₀, C₇₀, PC60BM and PC70BM.

5. The perovskite solar cell of claim 2, wherein the carbon-based electron transport layer and the passivation buffer layer have a thickness ratio of 1:0.01 to 0.2, and
wherein the carbon-based electron transport layer and the hole blocking buffer layer have a thickness ratio of 1:0.01 to 0.2.

6. The perovskite solar cell of claim 2, wherein the passivation buffer layer and the hole blocking buffer layer each have an average thickness of 0.5 to 5 nm, and
wherein the carbon-based electron transport layer has an average thickness of 3 to 30 nm.

7. The perovskite solar cell of claim 1, wherein the electron transport layer and electron transport buffer layer have a thickness ratio of 1:1.1 to 2.4.

8. The perovskite solar cell of claim 1, wherein the electron transport layer has an average thickness of 3 to 30 nm.

9. The perovskite solar cell according to any one of claims 1 to 8, wherein the perovskite solar cell is a p-i-n structured perovskite solar cell, an n-i-p inverted structured perovskite solar cell, a tandem perovskite solar cell or a tandem silicon/perovskite heterojunction solar cell.

10. A method for producing a perovskite solar cell, the method comprising:
step 1 of forming a perovskite light-absorbing layer on top of a hole transport layer;
step 2 of forming an electron transport buffer layer on top of the perovskite light-absorbing layer through a deposition process or a solution process; and
step 3 of sequentially forming an electron transport layer, a transparent electrode and a metal electrode on top of the electron transport buffer layer,
wherein the electron transport buffer layer comprises one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

11. The method of claim 10, wherein step 2 comprises:
step 2-1 of forming a passivation buffer layer on top of a perovskite light-absorbing layer through a deposition process or a solution process;
step 2-2 of forming a carbon-based electron transport layer on top of the passivation buffer layer through a deposition process or a solution process; and
step 2-3 of forming a hole blocking buffer layer on top of the carbon-based electron transport layer through a deposition process or a solution process.

12. A tandem silicon/perovskite heterojunction solar cell that is a heterojunction solar cell in which a solar cell, a transparent conductive layer, a hole transport layer, a perovskite light-absorbing layer, an electron transport buffer layer, an electron transport layer, a transparent electrode and a metal electrode are sequentially laminated, wherein the electron transport buffer layer comprises one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂).

13. The tandem silicon/perovskite heterojunction solar cell of claim 12, wherein the electron transport buffer layer is a structure in which a passivation buffer layer, a carbon-based electron transport layer and a hole blocking buffer layer are sequentially laminated, and
wherein the passivation buffer layer is laminated on one surface of the perovskite light-absorbing layer, and the hole blocking buffer layer is laminated on one surface of the electron transport layer.

14. The tandem silicon/perovskite heterojunction solar cell of claim 13, wherein each of the passivation buffer layer and the hole blocking buffer layer comprises one or more selected from lithium fluoride (LiF), magnesium fluoride (MgF₂), cesium fluoride (CsF), sodium fluoride (NaF), potassium fluoride (KF), aluminum fluoride (AlF₃), aluminum oxide (Al₂O₃) and calcium fluoride (CaF₂), and
wherein the carbon-based electron transport layer comprises a fullerene series organic material.

15. The tandem silicon/perovskite heterojunction solar cell of claim 12, wherein the solar cell is a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.
